# EUROPEAN PATENT APPLICATION

(11) **EP 4 672 331 A1**
(43) Date of publication of application: **31.12.2025**
(21) Application number: 24184956.1
(22) Date of filing: 27.06.2024
(51) Int. Cl.: H01L 23/495, H01L 23/31

(54) **SEMICONDUCTOR DEVICE WITH PLATED CLIP AND FLIP-CHIP INTERCONNECT ON LEADFRAME**

(71) Applicant: Nexperia B.V., 6534 AB Nijmegen (NL)
(72) Inventor: Poelma, Regnerus Hermannus, Nijmegen (NL); Böttcher, Tim, Hamburg (DE); Funke, Hans-Juergen, Hamburg (DE); Wong, Wai Man, Guangdong (CN); Cheung, Yuet Keung, Hong Kong (HK); Bernhardt, Dirk, Hamburg (DE)
(74) Representative: Pjanovic, Ilija

(57) **Abstract**

A semiconductor device (100) and manufacturing method thereof are presented. The device has a top side and a bottom side and comprises a leadframe with pads (110A, 112, 114) extending to the bottom side of and exterior to the device. At least one of the pads comprises a leadframe vertical protrusion (110B) extending from the bottom side to the top side. A die (200) is flip-chip arranged in the semiconductor device and comprises terminals (202, 204, 206). At least one of the terminals (202, 204) on the top side of the die and facing the bottom side of the device is electrically connected to a corresponding pad (112, 114). Another one of the terminals (206) on the bottom side of the die faces the top side of the device where a conductive film (102) electrically connects the terminal (206) to the leadframe vertical protrusion (110B) at the top side.

## Description

### Technical field

The present disclosure relates semiconductor device packaging, and in particular to a semiconductor device, a leadframe of a semiconductor device and a method of manufacturing a plurality of semiconductor devices.

### Background

Traditional wire bonding methods used for semiconductor power devices presents significant limitations when handling high current densities. This limitation results in an increased reliance on clip bonding techniques for high-power semiconductor devices. While clip bonding offers superior electrical performance and heat distribution compared to wire bonding, it introduces its own set of challenges. For example, the process of clip bonding is complex and requires multiple manufacturing steps including the application of solder, the precise pick-and-place of the clip, a solder reflow stage, a flux cleaning step and an inspection to verify the quality of the bond. Each of these steps not only increases the manufacturing time but also contributes to a higher overall cost of the device. Furthermore, the complexity of the process increases the risk of production errors, which can lead to reliability and lifespan issues of the power semiconductor devices. Moreover, the increased time and costs, combined with the potential decreased device reliability, limits the production of highcurrent semiconductor power devices. These problems showcase the need for a new solution that can handle high current densities while simplifying the manufacturing process, reducing costs, and ensuring the reliability of semiconductor power devices.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure overcome the drawbacks identified in the background section.

According to an aspect of the present disclosure, a semiconductor device is presented. The semiconductor device has a top side and a bottom side. The semiconductor device may include a leadframe comprising a plurality of pads extending to the bottom side of and exterior to the semiconductor device. At least one of the pads may include a leadframe vertical protrusion extending from the bottom side to the top side. The semiconductor device may further include a die that is flip-chip arranged in the semiconductor device. The die may include a plurality of terminals. At least one of the terminals on the top side of the die and facing the bottom side of the semiconductor device may be electrically connected to a corresponding pad. Another one of the terminals on the bottom side of the die faces the top side of the semiconductor device. The semiconductor device may further include a conductive film on the top side of the semiconductor device. The conductive film may be electrically connected to the other one of the terminals and to the leadframe vertical protrusion at the top side.

In an embodiment, the plurality of pads may include a source pad, a gate pad and a drain pad. The at least one of the terminals on the top side of the die may include a source or a gate. The other one of the terminals on the bottom side of the die may be a drain.

In an embodiment, the bottom side of the semiconductor device may be exposed after flip-chip and (e.g., film assisted) moulding or back grinding in such a way that the bottom side is co-planar with the pads through mould protrusion.

In an embodiment, the conductive film may include a sputtered or plated interconnect film forming a lateral electrical contact on the top side of the semiconductor device.

In an embodiment, the conductive film may be a layer of conductive material, preferably a layer of copper.

In an embodiment, one or more of the plurality of pads may include a further leadframe vertical protrusion extending from the bottom side to the top side and being exposed at the top side of the semiconductor device.

In an embodiment, the leadframe may include parts of connection bars that are left after singulating the semiconductor device from a plurality of semiconductor devices that are kept together by the connection bars prior to the singulation of the semiconductor device from the plurality of semiconductor devices.

In an embodiment, the semiconductor device may be a semiconductor power device. In an embodiment, the semiconductor device may be a MOSFET. In an embodiment, the semiconductor device may be a rectifier. In an embodiment, the semiconductor device may be a bipolar transistor.

In an embodiment, the semiconductor device may include a Micro Chip Carrier (e.g., MCD) package with a top-cool feature or a double (two-sided) cooled feature.

In an embodiment, the semiconductor device may be a leadless semiconductor device.

According to an aspect of the present disclosure, a leadframe of a semiconductor device is presented. The leadframe may include a plurality of pads oriented in a plane. At least one of the pads may include a leadframe vertical protrusion extending from the plane.

In an embodiment, the leadframe may be for use in a semiconductor device having one or more of the above described features.

According to an aspect of the present disclosure, a method of manufacturing a plurality of semiconductor devices is presented. The method may include providing a main leadframe including a plurality of leadframes that are connected by connection bars. Each of the plurality of leadframes may include a plurality of pads. At least one of the pads may include a leadframe vertical protrusion extending from the at least one of the pads. The method may further include providing a plurality of dies. The method may further include flip-chip connecting each of the dies to its respective leadframe resulting in a die-leadframe assembly. The method may further include moulding the die-leadframe assembly to form a moulded die-leadframe assembly. The method may further include depositing a conductive film on a top side of the moulded die-leadframe assembly to obtain a conductive film covered assembly. The conductive film electrically may connect a terminal on a bottom side of each of the dies to the at least one of the pads via the leadframe vertical protrusion. The method may further include singulating the conductive film covered assembly by cutting or sawing along cutting lines to obtain the semiconductor devices.

In an embodiment, the singulating may result in the connection bars to be cut and electrical connections between pads through the connection bars to be broken.

In an embodiment, each of the plurality of semiconductor devices may be a semiconductor device having one or more of the above described features.

### Brief description of the Drawings

Embodiments of the present disclosure will now be described, by way of example only, with reference to the accompanying schematic drawings in which corresponding reference symbol indicate corresponding parts, in which:
Figs. 1A-1C show a non-limiting example embodiment of a semiconductor device, with Fig. 1A showing a 3D view of a top side of the semiconductor device, Fig. 1B showing a 3D view of a bottom side of the semiconductor device and Fig. 1C showing a 2D cross-sectional side view of the semiconductor device;
Fig. 2 shows a 3D view of an example die;
Fig. 3A shows a 3D view of an example embodiment of a main leadframe;
Fig. 3B shows a 3D view of a part of a main leadframe in more detail;
Fig. 4A shows a 3D view of an example embodiment of a die-leadframe assembly;
Fig. 4B and Fig. 4C show a 3D and 2D view, respectively, of a part of a die-leadframe assembly in more detail;
Figs. 5A and Fig. 5B show 3D views of a top side and a bottom side, respectively, of a moulded die-leadframe assembly;
Fig. 6 shows a 3D view of a conductive film covered assembly;
Fig. 7 shows a 3D view of a conductive film covered assembly after singulation;
Fig. 8A and Fig. 8B shows another non-limiting example embodiment of a semiconductor devices, with Fig. 8A showing a 3D view of a top side of the semiconductor device and Fig. 8B showing a 3D view of a bottom side of the semiconductor device;
Fig. 9 shows a 3D bottom view of a die-semiconductor device leadframe assembly;
Fig. 10 shows a 3D view of an example embodiment of a main leadframe;
Fig. 11 shows a 3D view of an example embodiment of a die-leadframe assembly;
Fig. 12 shows a 3D view of a moulded die-leadframe assembly;
Fig. 13 shows a 3D view of a conductive film covered assembly;
Figs. 14A and 14B show 3D views of a top side and a bottom side, respectively, of a conductive film covered assembly after singulation; and
Fig. 15 shows an example process of manufacturing a plurality of semiconductor devices.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

Flip-chip semiconductor packaging is an advanced packaging technology used to mount and connect semiconductor chips (also known as dies) directly onto the substrate or package carrier, with the active surface of the chip facing downwards. In flip-chip packaging, the electrical connections are typically made through conductive bumps (solder bumps or copper pillars) on the chip's surface, which are then directly bonded to corresponding pads on the substrate or package carrier.

Flip-chip semiconductor devices offer several advantages over traditional wire-bonded or leadframe-based packages. Flip-chip packaging allows for a higher density of interconnects between the chip and the substrate, enabling more functionality in a smaller footprint. Furthermore, with the direct connection between the chip and substrate, flip-chip packaging reduces the length of electrical paths, leading to improved electrical performance, reduced signal delay, and enhanced high-frequency operation. Moreover, flip-chip packaging allows for better thermal dissipation due to the direct connection between the chip and substrate, reduces parasitic capacitance and inductance compared to wire-bonded packages, and has fewer interconnects compared to wire-bonded packages, reducing the risk of wire bonding failures and improving overall reliability.

The solution of the present disclosure pertains to a novel flip-chip packaging solution for semiconductor devices, like diodes and transistors, allows a high power density demand and provides superior thermal dissipation. The solution is based on a combination of Panel Level Packaging (PLP) and Dual Flat No-lead (DFN) / Quad Flat No Lead (QFN) leadframe assembly. PLP is a type of semiconductor package where the integrated circuit (IC) is mounted onto a temporary flat substrate and connected through Cu redistribution layers and vias. Typically the chips are lateral semiconductors (ICs) and not vertical devices such as MOSFETs, Bipolar transistors, and diodes. DFN and QFN are typical leadframe based packages where the leadframe provides physical support and electrical connections for the IC. The chip is typically mounted in the center of the leadframe and connected by wirebonds or clip bonds on the top, for the leaded version the leads extend outwards from the package, allowing for easy soldering onto a circuit board, for the leadless variety, the leads stay within the package body. PLP packages are commonly used for various integrated circuits due to their potential low cost coming from the scalability of large panels, ease of manufacturing, and compatibility with surface mount technology (SMT). DFN/QFN is a type of leadframe assembly where the package has no leads protruding from its sides. Instead, it typically has small contact pads on the bottom surface, allowing for direct soldering to a circuit board. DFN/QFN packages are characterized by their small size, low profile, and excellent thermal and electrical performance. They are often used in applications where space is limited and high-density packaging is required, such as in mobile devices, consumer electronics, and automotive electronics.

The solution of the present disclosure includes a leadframe based package with a plated interconnect. Advantageously, this allows for elimination of the sequential clip bonding and soldering process by a process which realizes the interconnect in parallel on the entire panel by sputtering and plating or printing or a laminated conductive film. After singulation, the package may be leadless and separated from the device array. Furthermore, with the solution of the present disclosure, warpage after moulding may be less critical compared to PLP due to the smaller leadframe "panel" sizes and structural copper (Cu) leadframe (LF) support. Moreover, the package construction does not require via drilling which is often a considerable cost-adder for PLP, since the leadframe has a vertical protrusion (110B) connecting package top and bottom. Moreover, the solution of the present disclosure enables top cool solutions and package heat dissipation with a double side cooled configuration, e.g., in Micro Chip Carrier (MCD).

The semiconductor device of the present disclosure includes a die flip-chip connected to a leadframe map with leadframe vertical protrusions. After die attachment and (film assisted) overmould and/or back grinding, the leadframe vertical protrusion and die bottom side are exposed thereby allowing for a sputtered or plated or printed interconnect film to be applied. This conductive film allows for die bottom side connection to the leadframe. Afterwards, the devices are singulated by dicing.

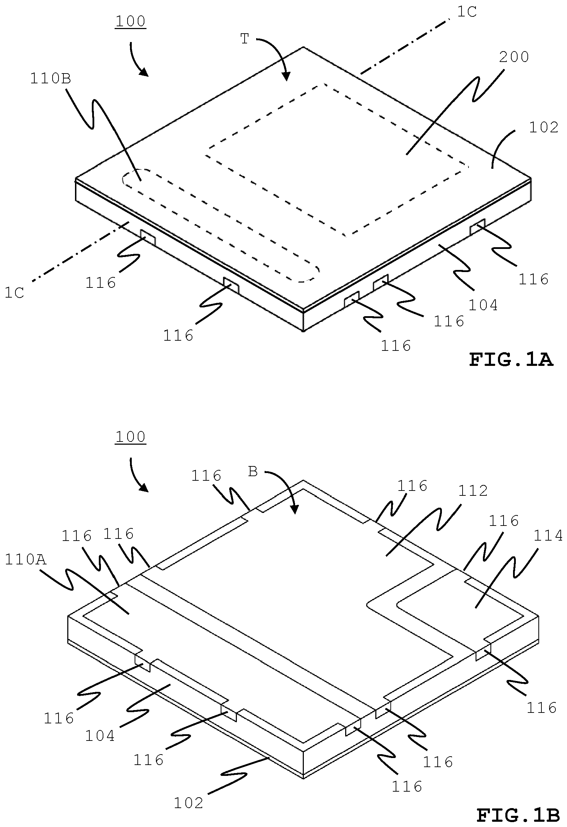

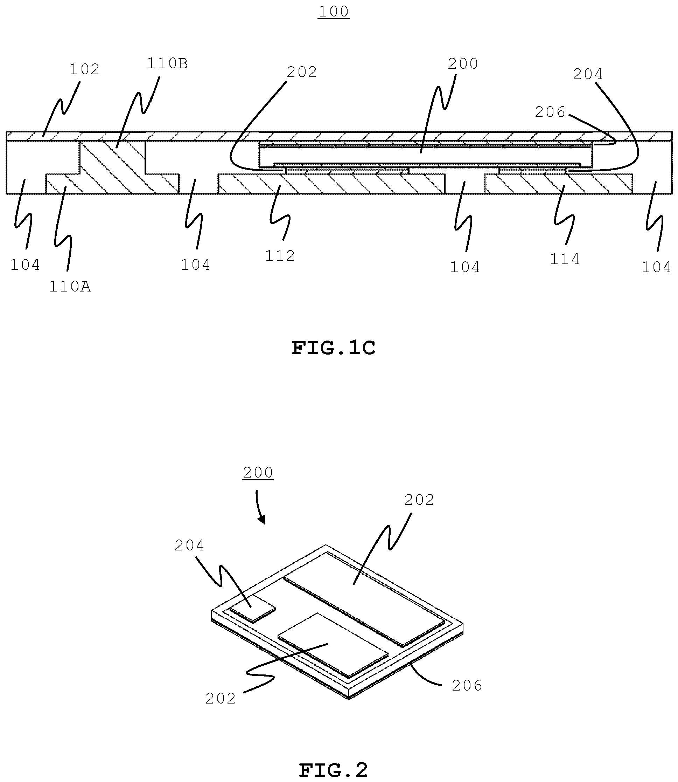

A non-limiting example embodiment of a semiconductor device 100 of the present disclosure is shown in Fig. 1A, Fig. 1B and Fig. 1C. Fig. 1A is a 3D view of a top side (depicted "T") of the semiconductor device 100. Fig. 1B is a 3D view of a bottom side (depicted "B") of the semiconductor device 100. Fig. 1C is a 2D cross-sectional side view of the semiconductor device 100, shown along the view line 1C indicated in Fig. 1A.

With reference to Fig. 1C, the semiconductor device 100 may include a die 200 having its source 202, gate 204 and drain 206 electrically connected to a source pad 112, a gate pad 114 and a drain pad 110A, respectively. The die 200 is located within the semiconductor device 100 and the source pad 112, the gate pad 114 and the drain pad 110A are exposed on the outside at the bottom of the semiconductor device 100 allowing external connections to be made to the die 200. The drain 206 is further connected to a conductive film 102 that is exposed on the outside at the top of the semiconductor device 100. The conductive film 102 may be a redistribution layer (RDL). The conductive film may be a sputtered or plated or printed interconnect film forming a clip on the top side of the semiconductor device 100. The conductive film 102 may be a laminated Cu film. Moulding material 104 may isolate electrically conductive materials and form the semiconductor packaging of the semiconductor device 100.

A 3D view of an example die 200 is shown in isolation in Fig. 2. The source 202 and the gate 204 may be located on one side of the die 200. The drain 206 may be located on the other side of the die 200. There may be multiple source connections on a die, e.g., two sources 202 as shown in the example of Fig. 2.

In Fig. 1C, the source pad 112 and the gate pad 114 are located on the bottom side of the semiconductor device 100. The drain pad 110A and the conductive film 102 enable both the bottom side and the top side of the semiconductor device 100 to be electrically connected to the drain 206. At the bottom side, the drain pad 110A includes a surface area that is level with the surface areas of the source pad 112 and the gate pad 114. The drain pad 110A includes a leadframe vertical protrusion 110B that interconnects the drain pad 110A at the bottom side of the semiconductor device 100 with the conductive film 102 at the top side of the semiconductor device. The conductive film 102 on the top side of the semiconductor device 100 is electrically connected to the drain 206 and to the leadframe vertical protrusion 110B, thereby connecting the drain 206, via the leadframe vertical protrusion 110B, to the drain pad 110A at the bottom of the semiconductor device 100.

The conductive film 102 may be applied to the entire top side of the semiconductor device 100, such as shown in Fig. 1A where the dashed leadframe vertical protrusion 110B and the dashed die 200 are located below the conductive film 102. Advantageously, no lithography is required for creating the conductive film 102.

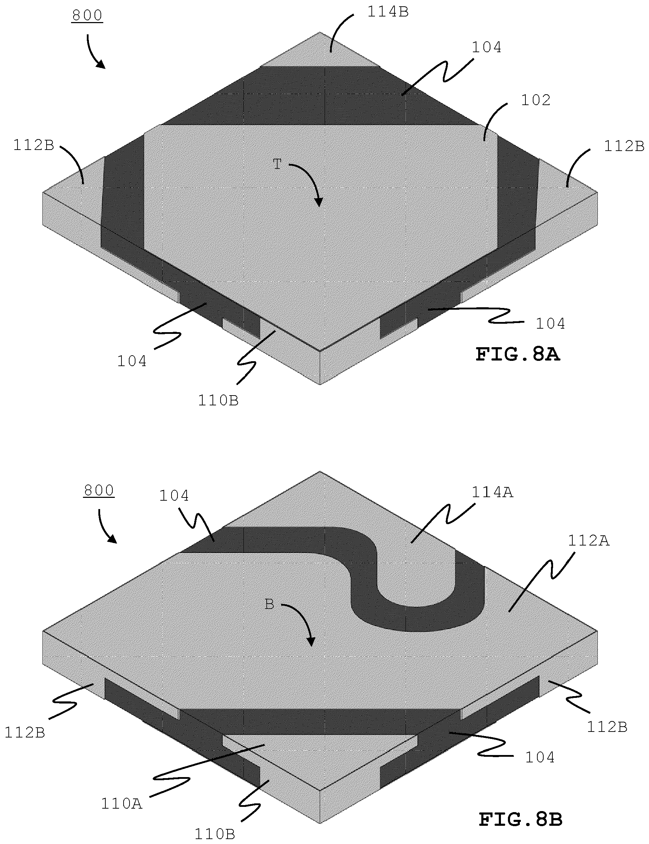

In an alternative embodiment, also the source pad and/or the gate pad located at the bottom side of the semiconductor device may be connected to plated clips at the top side of the semiconductor device via respective leadframe vertical protrusions. An example of such alternative semiconductor device 800 is shown in Figs. 8A and 8B, which will be described in more detail below.

The bottom side of the semiconductor device 100 may include the source pad 112, the gate pad 114 and the drain pad 110A, wherein the source pad 112 typically has the largest surface area and the gate pad 114 typically has the smallest surface area, such as shown in Fig. 1B. The source pad 112, gate pad 114 and drain pad 110A may be separated by the moulding material 104.

The semiconductor device 100 may be manufactured in multiples at the same time, wherein, during manufacturing, the semiconductor devices being manufactured are connected via connection bars 116. In particular, during the manufacturing stages up to singulation, a main leadframe may include a plurality of semiconductor device leadframes that are interconnected by the connection bars 116, thereby keeping the source pads 112, the gate pads 114 and the drain pads 110A including leadframe vertical protrusions 110B of each semiconductor device being manufactured in place. After singulation, parts of the connection bars 116 may remain in each semiconductor device 100, such as shown in Figs. 1A and 1B.

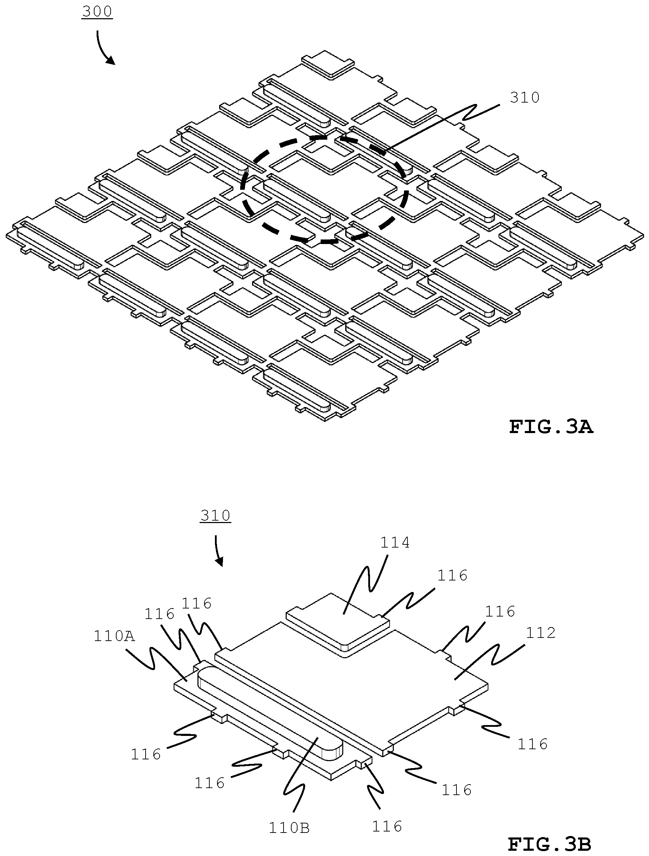

A main leadframe may include any number of semiconductor device leadframes, depending on manufacturing constrains. An example embodiment of a main leadframe 300 including sixteen semiconductor device leadframes 310, herein also referred to as leadframes or leadframe in singular form, is shown in Fig. 3A. In this example, the semiconductor device leadframes 310 are arranged in a 4x4 grid in the main leadframe 300. The main leadframe 300 typically consists of a conductive material, such as Cu, and may be created using any known technique, such as stamping or etching. Preferably, the main leadframe 300 is created as a half-etched inverted MCD leadframe.

With reference to Fig. 3B, integral part of the main leadframe 300 are the leadframe vertical protrusions 110B in each semiconductor device leadframe 310. For the semiconductor device 100, each semiconductor device leadframe 310 includes the source pad 112, the gate pad 114, the drain pad 110A and the leadframe vertical protrusion 110B. Moreover, the main leadframe 300 includes the connection bars 116.

Half-etched leadframes in a map mould configuration are widely available in the industry. However, the half-etching step is normally used to create mould adhesion features and/or side wettable flanks. In the present disclosure, the main leadframe 300 may be created using half-etching, wherein moreover the half-etching may be used to create the vertical top-side protrusion, such as the leadframe vertical protrusion 110B, for the die clip attach connection.

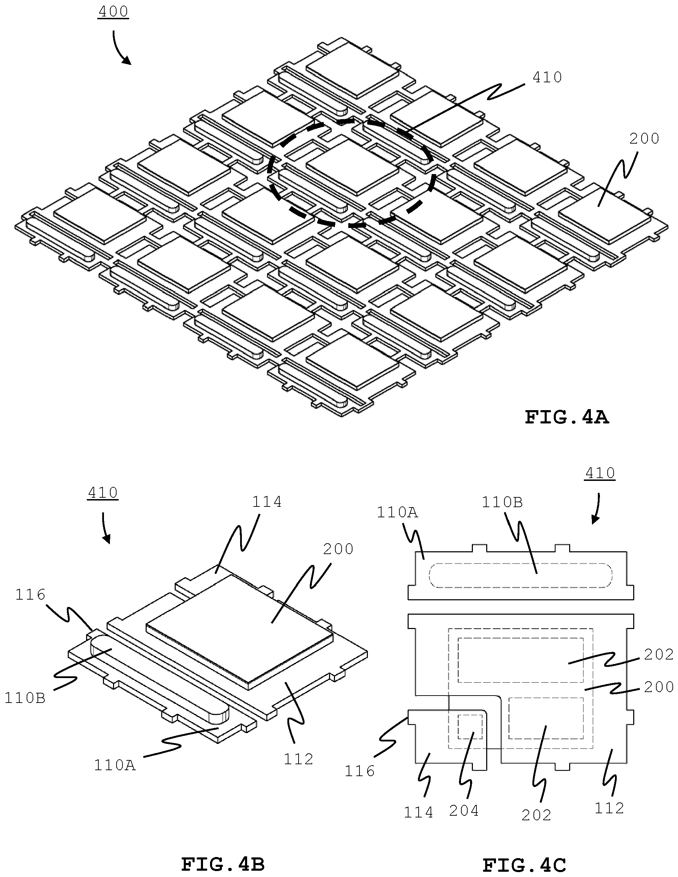

The dies 200 of each semiconductor device 100 may be flip-chip connected to the main leadframe 300, resulting in the die-leadframe assembly 400 as shown in Fig. 4. Advantageously, by doing the flip-chip connection on a die 200, e.g., a vertical power MOSFET, to connect source and gate of the die 200 to a semiconductor device leadframe 310, the most complicated step in the manufacturing process is performed at the beginning. I.e., the first die-attach step has the highest alignment accuracy of die to leadframe, which can potentially lead to less yield loss and faster assembly when compared to pick and place for clip attach to source and gate.

A single die-semiconductor device leadframe assembly 410 is shown in more detail in Figs. 4B and 4C. Fig. 4B is similar to Fig. 3B, with the bottom side of the die 200 being electrically connected to the semiconductor device leadframe 310. Fig. 4C shows a bottom side view of a die-semiconductor device leadframe assembly 410, invisible parts on the other side of the bottom side view being indicated in dashed lines. As can be seen in Fig. 4C, the die 200 is aligned with the semiconductor device leadframe 310 such that the sources 202 of the die 200 electrically connect with the source pad 112 of the semiconductor device leadframe 310 and the gate 204 of the die 200 electrically connects with the gate pad 114 of the semiconductor device leadframe 310. Note that the drain 206 is exposed at the top side of the die 200 after connecting the die 200 to the semiconductor device leadframe 310.

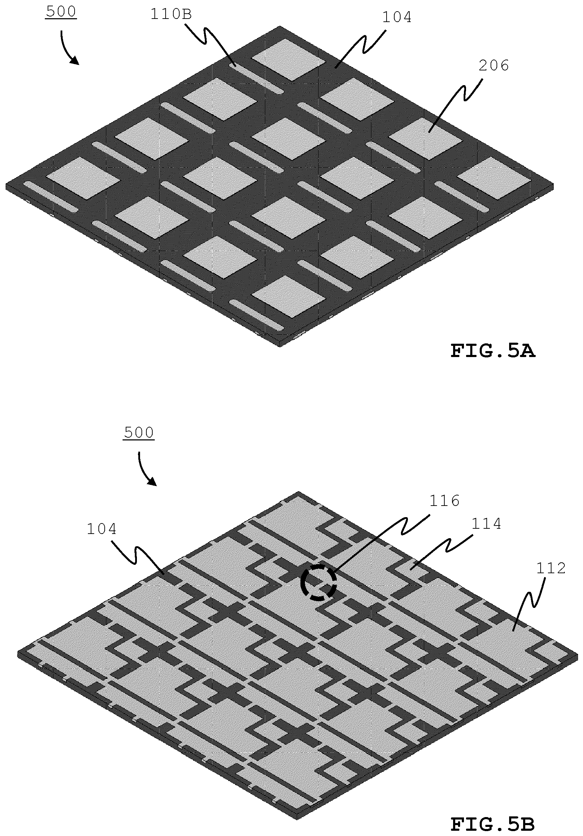

After connecting the dies 200, the main leadframe 300 including dies 200 may be moulded using a moulding material 104 to form the moulded die-leadframe assembly 500 as shown in Figs. 5A and 5B. After moulding, the leadframe vertical protrusions 110B and the drains 206 are exposed at the top side (see Fig. 5A) and the source pads 112 and the gate pads 114 are exposed at the bottom side (see Fig. 5B). Also visible are the connection bars 116 (only one connection bar is shown in Fig. 5B).

Advantageously, (film assisted) molding (or back grinding) of the entire map exposes both the leadframe at the top using the leadframe top protrusion and the die bottom side / drain connections to be at the same co-planar level. This step is wellscalable since it can be applied to the entire leadframe matrix or die array. Optionally, a wafer Bottom side Metallization (BSM) may be omitted for additional cost reduction.

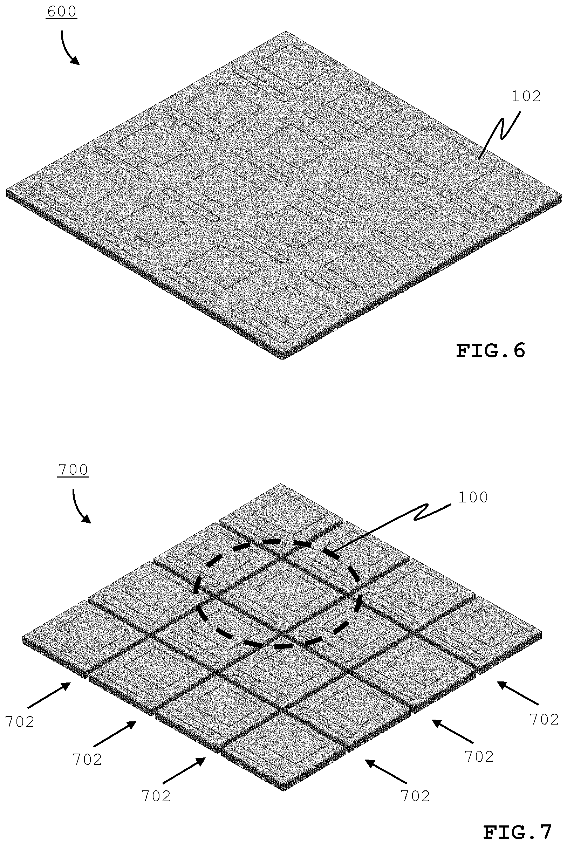

After moulding, a conductive film 102, i.e., a layer of conductive material such as a layer of Cu, may be deposited on the top side of the moulded die-leadframe assembly 500. Cu may be deposited using Cu metallization of Epoxy Molding Compound (EMC). An example of a resulting conductive film covered assembly 600 is shown in Fig. 6, where a conductive film 102 is shown covering whole of the top side of the moulded die-leadframe assembly 500. The conductive film 102 covers and electrically connects the leadframe vertical protrusions 110B and the drains 206.

Advantageously, metallization of the entire strip may be achieved by sputtering and plating or printing, to create the interconnection of the conductive film 102 to die 200/206 and leadframe 300/110B. This has the main advantage that it is a parallel process. For example, a titanium (Ti) adhesion layer, which potentially doesn't undergo hot sputtering and annealing, could be suitable for silicon (Si) devices that have been pre-moulded with EMC. Here all the semiconductor devices in the array/matrix are connected in the same step as opposed to the sequential pick-and-place alternatives. Thereby providing the advantages of higher throughput (e.g. more units per hour produced) as compared to pick and placing and soldering of clips.

The individual semiconductor devices 100 may be finally obtained by singulation of the conductive film covered assembly 600, such as shown in Fig. 7. Singulation of the entire strip 700 by cutting or sawing along cutting lines 702 advantageously requires no additional lithography steps or patterning steps since the sawing action also separates the plated / sputtered clip interconnect and cuts through all the connection bars 116, leading to a significant cost reduction.

A non-limiting example of a die 200 is a vertical die such as a metal-oxide-semiconductor field-effect transistor (MOSFET) with the source 202 and the gate 204 connection on one side and the drain 206 connection on the opposing side. The die may be flip-chip bonded to a semiconductor device leadframe and a conductive film 102 connection may made between die drain and semiconductor device leadframe.

Figs. 8A and 8B show another non-limiting example embodiment of a semiconductor device 800 including a plurality of leadframe vertical protrusions not only connecting a drain pad 110A at a bottom side of the semiconductor device 800 to a conductive film 102 at a top side of the semiconductor device 800 for connection with the drain 206 of the die 200, such as in the semiconductor device 100, but also bringing a source pad 112A at the bottom side to the top side through a leadframe vertical protrusion 112B and bringing a gate pad 114A at the bottom side to the top side through a leadframe vertical protrusion 114B. Fig. 8A is a 3D view of the top side (depicted "T") of the semiconductor device 800. Fig. 8B is a 3D view of the bottom side (depicted "B") of the semiconductor device 800. Also shown is moulding material 104.

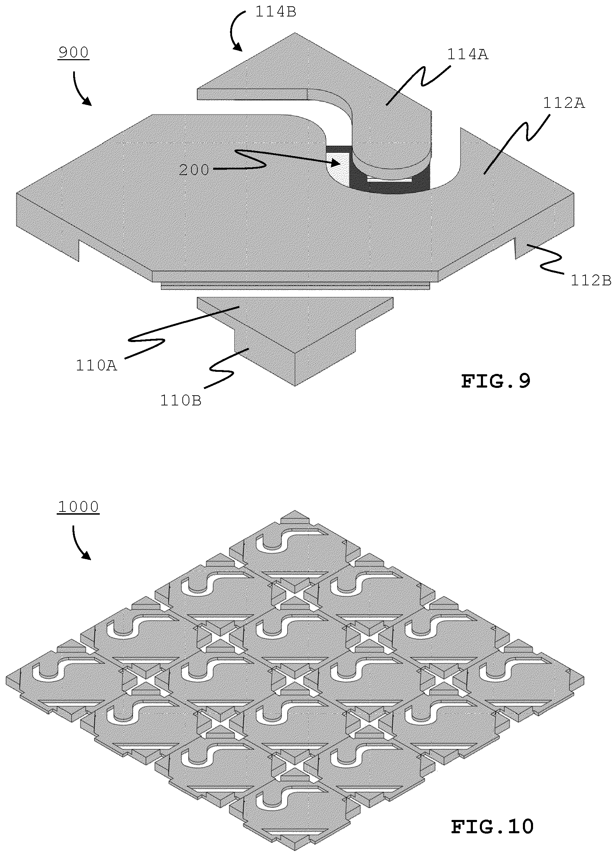

Fig. 9 shows a 3D bottom view of a die-semiconductor device leadframe assembly 900 of the semiconductor device 800. The die-semiconductor device leadframe assembly 900 includes the drain pad 110A, the source pad 112A and the gate pad 114A. Furthermore, the die-semiconductor device leadframe assembly 900 includes a leadframe vertical protrusion 110B, a leadframe vertical protrusion 112B and a leadframe vertical protrusion 114B for each of the drain pad 110A, source pad 112A and gate pad 114A, respectively. A source and a gate of a die 200 may be electrically connected to the source pad 112A and the gate pad 114A.

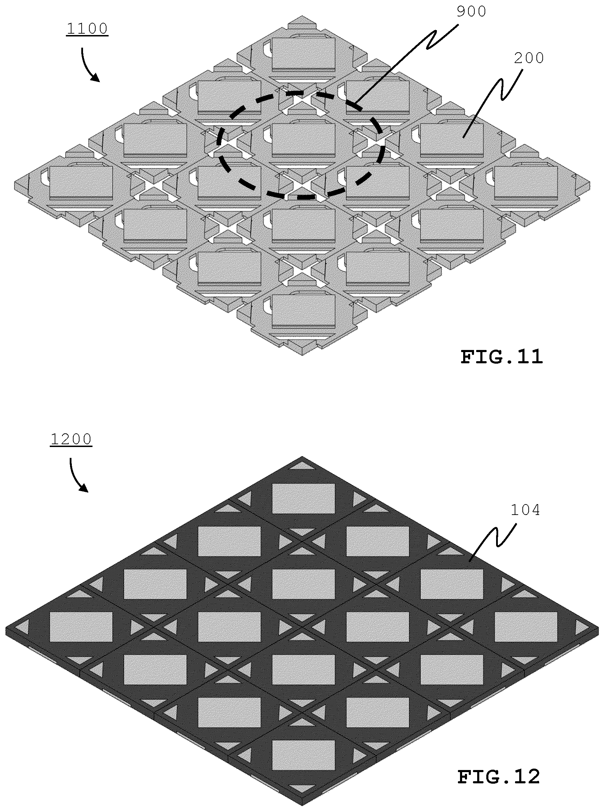

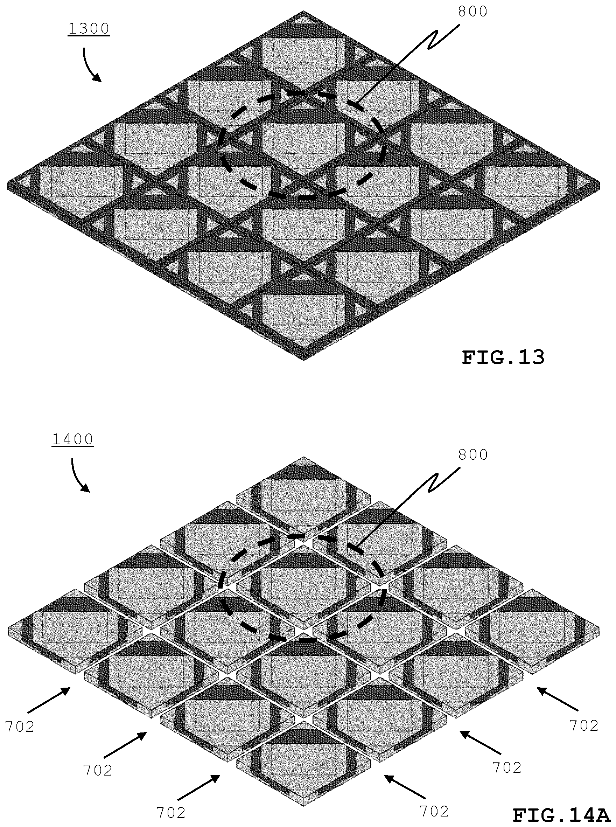

Similar to the main leadframe 300 of Fig. 3A, the manufacturing of a plurality of semiconductor devices 800 may be based on a main leadframe 1000, such as shown in Fig. 10. After connecting the die 200 to the main leadframe 1000, the die-leadframe assembly 1100 of Fig. 11, similar to the die-leadframe assembly 400, may be obtained, including a plurality of die-semiconductor device leadframe assemblies 900. The moulded die-leadframe assembly 1200 of Fig. 12 may be created, similar to the moulded die-leadframe assembly 500, followed by a selective deposition of a conductive film 102, i.e., a layer of conductive material such as a layer of Cu, on the top side of the moulded die-leadframe assembly 1200 to obtain the conductive film covered assembly 1300 such as shown in Fig. 13.

The conductive film covered assembly 1300 differs from the conductive film covered assembly 600 in that only on a part of top side of the moulded die-leadframe assembly 1200 the Cu is deposited, i.e., the part connecting the drain 206 of the die 200 with the leadframe vertical protrusion 110B connected to the drain pad 110A. The leadframe vertical protrusions 112B and 114B are kept free of the Cu deposition and moulding material 104 separates the leadframe vertical protrusions 112B and 114B from the leadframe vertical protrusion 110B and the conductive film 102.

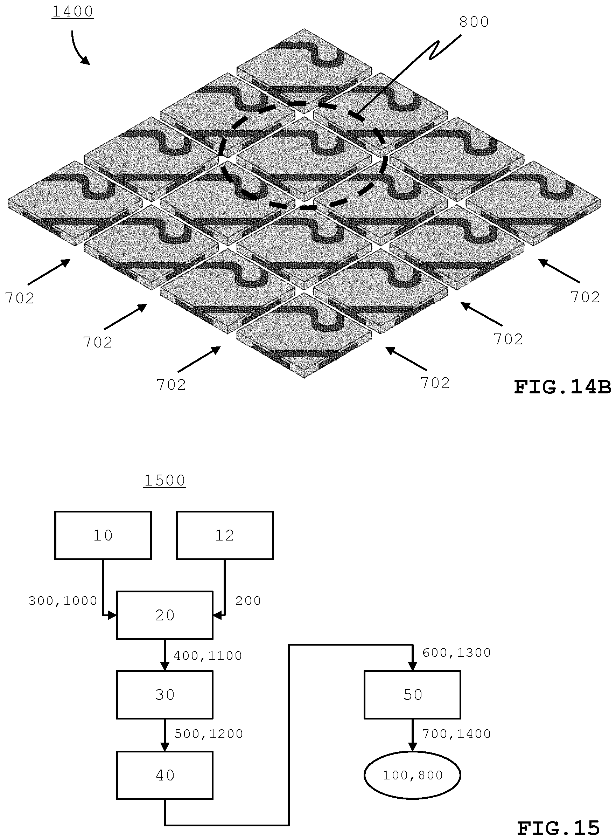

After singulation of the entire strip 1400 along cutting lines 702, the individual semiconductor devices 800 may be obtained, such as shown in Fig. 14A and Fig. 14B, with Fig. 14A showing the top side and Fig. 14B showing the bottom side of the semiconductor devices 800.

In the above examples, the die 200 includes three terminals, i.e., a source 202, a gate 204 and a drain 206, that are electrically connected to corresponding pads extending to the exterior bottom side of the semiconductor device 100, 800, i.e., a source pad 112, 112A, a gate pad 114, 114A and a drain pad 110A. One or more of the pads 112, 112A, 114, 114A, 110A include a leadframe vertical protrusion 110B, 112B, 114B to bring the bottom side pad(s) to the exterior top side of the semiconductor device 100, 800. The die 200 is arranged in a flip-chip configuration within the semiconductor device 100, 800 resulting in the bottom side of the die 200 being oriented towards the top side of the semiconductor device 100, 800. A pad on the exterior bottom side of the semiconductor device is connected to a terminal on the die bottom side, such as the drain pad 110A being connected to the drain 206 via the leadframe vertical protrusion 110B and the conductive film 102.

The present disclosure is not limited to dies having three terminals. For example, the die may be a diode including two terminals or any other semiconductor device having any number of terminals. Moreover, the semiconductor device is not limited to a single die. For example the device can have any number of smaller dies which fit inside the package.

Generally, the present disclosure presents a leadframe vertical protrusion, e.g., 110B, on the top side of the leadframe, e.g., 310, to bring a bottom side pad, e.g., the bottom side drain pad 110A, of the leadframe to the top of the package in such a way it can be connected with the die bottom side, with the die being arranged in a flip-chip configuration. Optionally, in a similar manner other pads, such as the bottom side source pad 112A, and/or the bottom side gate pad 114A, may be brought to the top side of the package through respective leadframe vertical protrusions, e.g., 112B, 114B.

The semiconductor device, e.g., 100, 800, may have an exposed die bottom side after flip-chip and (film assisted) moulding or back grinding in such a way that it is at the same level / co-planar as the leadframe vertical protrusion through mould protrusion.

The semiconductor device, e.g., 100, 800, may include a sputtered seed layer and plated clip (conductive film 102) to connect the leadframe vertical protrusion to the die bottom side.

Both a Si substrate and Cu bump may be grinded and EMC backed and then the entire metal layer may be directly sputtered. Ti is not necessarily hot sputtered and annealed. This may eliminate BSM.

Package singulation may be achieved in such a way that the individual semiconductor packages, e.g., 100, 800, are created from a map-moulded device array held together before singulation by dam bars, e.g., connection bars 116, of the frame protruding on the package sides.

The semiconductor device 100, 800 may be a semiconductor power device.

The semiconductor device 100, 800 may be an MCD package with a top-cool feature or a double (two-sided) cooled feature.

The semiconductor device 100, 800 of the present disclosure may advantageously be used in switching power supplies, e.g., in mobile devices and personal computers where compact diode and MOSFET packages may be used together in power supply systems.

The semiconductor device 100, 800 of the present disclosure may advantageously be used in electric and hybrid electric vehicles (HEVs), where the emphasis on energy efficiency and the reduction of size and weight in EVs and HEVs drive the use of miniaturized MOSFET power packages. The semiconductor devices 100, 800 may be used as components in battery management systems, motor controllers, and onboard chargers.

The semiconductor device 100, 800 of the present disclosure may advantageously be used in consumer electronics and appliances. In home appliances like air conditioners, refrigerators, and televisions, small diode packages and MOSFETs may be used together for efficient power conversion and control.

In an embodiment, a single semiconductor device created from a main leadframe, such as 300, 1000, may include multiple chips inside, e.g., multiple dies 200, for example in the form of a half-bridge.

The outer dimensions of a package and die are not limited to the examples shown in the figures and may be different.

The semiconductor device of the present disclosure is not limited to three leads or pads and may include more than 3 leads or pads.

In an embodiment, the semiconductor device 100, 800 may include side wettable flanks.

Fig. 15 shows an example process 1500 of manufacturing a plurality of semiconductor devices 100, 800. In step 10 a main leadframe 300, 1000 including one or more leadframe vertical protrusions 110B, 112B, 114B is provided and in step 12 a die 200 is provided. In step 20, the die 200 is flip-chip connected to the main leadframe 300, 1000 resulting in a die-leadframe assembly 400, 1100. In step 30, the main leadframe 300,100 including dies 200 may be moulded using a moulding material 104 to form a moulded die-leadframe assembly 500,1200. In step 40, a conductive film, i.e., a layer of conductive material such as Cu, may be deposited on the top side of the moulded die-leadframe assembly 500, 1200 to obtain a conductive film covered assembly 600, 1300 and electrically connecting a terminal 206 on the bottom side of the die 200 to a pad 110A on the bottom side of the semiconductor device 100, 800 via a leadframe vertical protrusion 110B. In step 50, the conductive film covered assembly 600, 1300 may be singulated by cutting or sawing along cutting lines 702 to obtain the semiconductor devices 100, 800.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A semiconductor device (100, 800) having a top side (T) and a bottom side (B), the semiconductor device comprising:
a leadframe (310) comprising a plurality of pads (110A, 112, 112A, 114, 114A) extending to the bottom side of and exterior to the semiconductor device, wherein at least one of the pads (110A) comprises a leadframe vertical protrusion (110B) extending from the bottom side to the top side;
a die (200) that is flip-chip arranged in the semiconductor device, the die comprising a plurality of terminals (202, 204, 206), wherein at least one of the terminals (202, 204) on the top side of the die and facing the bottom side of the semiconductor device is electrically connected to a corresponding pad (112, 112A, 114, 114A), and wherein another one of the terminals (206) on the bottom side of the die faces the top side of the semiconductor device; and
a conductive film (102) on the top side of the semiconductor device, wherein the conductive film is electrically connected to the other one of the terminals (206) and to the leadframe vertical protrusion (110B) at the top side.

2. The semiconductor device according to claim 1,
wherein the plurality of pads comprises a source pad (112, 112A), a gate pad (114, 114A) and a drain pad (110A),
wherein the at least one of the terminals on the top side of the die comprises a source (202) or a gate (204),
and wherein the other one of the terminals on the bottom side of the die is a drain (206).

3. The semiconductor device according to any one of the preceding claims, wherein the bottom side of the semiconductor device is exposed after flip-chip and (film assisted) moulding or back grinding in such a way that the bottom side is co-planar with the pads through mould protrusion (110B).

4. The semiconductor device according to any one of the preceding claims, wherein the conductive film comprises a sputtered or plated interconnect film forming a lateral electrical contact on the top side of the semiconductor device.

5. The semiconductor device according to claim 4, wherein the conductive film is a layer of conductive material, preferably a layer of copper.

6. The semiconductor device according to any one of the preceding claims, wherein one or more of the plurality of pads (112A, 114A) comprises a further leadframe vertical protrusion (112B, 114B) extending from the bottom side to the top side and being exposed at the top side of the semiconductor device.

7. The semiconductor device according to any one of the preceding claims, wherein the leadframe comprises parts of connection bars (116) that are left after singulating the semiconductor device from a plurality of semiconductor devices that are kept together by the connection bars prior to the singulation of the semiconductor device from the plurality of semiconductor devices.

8. The semiconductor device according to any one of the preceding claims, wherein the semiconductor device is a semiconductor power device, preferably a MOSFET or a rectifier or a bipolar transistor.

9. The semiconductor device according to any one of the preceding claims, wherein the semiconductor device comprises a Micro Chip Carrier (e.g., MCD) package with a top-cool feature or a double (two-sided) cooled feature.

10. The semiconductor device according to any one of the preceding claims, wherein the semiconductor device is a leadless semiconductor device.

11. A leadframe (310) of a semiconductor device (100, 800), the leadframe comprising a plurality of pads (110A, 112, 112A, 114, 114A) oriented in a plane, wherein at least one of the pads (110A) comprises a leadframe vertical protrusion (110B) extending from the plane.

12. The leadframe according to claim 12, wherein the leadframe is for use in a semiconductor device according to any one of the claims 1-10.

13. A method (1500) of manufacturing a plurality of semiconductor devices (100, 800), the method comprising:
providing (10) a main leadframe (300, 1000) including a plurality of leadframes (310) that are connected by connection bars (116), wherein each of the plurality of leadframes comprises a plurality of pads (110A, 112, 112A, 114, 114A) and wherein at least one of the pads (110A) comprises a leadframe vertical protrusion (110B) extending from the at least one of the pads;
providing (12) a plurality of dies (200);
flip-chip connecting (20) each of the dies (200) to its respective leadframe resulting in a die-leadframe assembly (400, 1100);
moulding (30) the die-leadframe assembly to form a moulded die-leadframe assembly (500,1200);
depositing (40) a conductive film (102) on a top side of the moulded die-leadframe assembly to obtain a conductive film covered assembly (600, 1300), wherein the conductive film electrically connects a terminal (206) on a bottom side of each of the dies to the at least one of the pads (110A) via the leadframe vertical protrusion;
singulating (50) the conductive film covered assembly by cutting or sawing along cutting lines (702) to obtain the semiconductor devices.

14. The method according to claim 13, wherein the singulating results in the connection bars to be cut and electrical connections between pads through the connection bars to be broken.

15. The method according to claim 13 or claim 14, wherein each of the plurality of semiconductor devices is a semiconductor device according to any one of the claims 1-10.
